# EUROPÄISCHE PATENTSCHRIFT

(11) **EP 1 453 194 B1**
(45) Veröffentlichungstag und Bekanntmachung des Hinweises auf die Patenterteilung: **08.04.2009**
(21) Anmeldenummer: 04002828.4
(22) Anmeldetag: 09.02.2004
(51) Int. Cl.: H03G 3/20, H04R 25/00

(54) **Verfahren zur automatischen Verstärkungseinstellung in einem Hörhilfegerät sowie Hörhilfegerät**
Method for automatic adjustment of an amplifier of a hearing aid and hearing aid
Méthode de l'ajustement automatique d'un amplificateur dans une prothèse auditive et prothèse auditive

(30) Priorität: 26.02.2003 DE 10308483
(43) Veröffentlichungstag der Anmeldung: 01.09.2004
(73) Patentinhaber: Siemens Audiologische Technik GmbH, 91058 Erlangen (DE)
(72) Erfinder: Chalupper, Josef, 85307 Paunzhausen (DE); Mergell, Patrick, Dr., Summerville Park Singapore 259293 (SG)
(74) Vertreter: Maier, Daniel Oliver

(56) Entgegenhaltungen:
- WO-A-00/65872
- WO-A-02/17678
- WO-A-87/00366
- US-A- 4 596 902

## Beschreibung

Für Schwerhörige stellt die Sprachverständlichkeit in einer Hörumgebung mit Störgeräuschen ein großes Problem dar. Durch eine geschickte Einstellung der zeit- und frequenzabhängigen Verstärkung eines akustischen Eingangssignals durch ein Hörhilfegerät kann eine Optimierung der Sprachverständlichkeit erreicht werden. Es stellt sich dabei das Problem, eine Vorschrift bzw. einen Algorithmus zu finden, der für beliebige, insbesondere auch zeitvariante, Sprachsignal/Störsignalmischungen eine optimale zeit- und frequenzabhängige Verstärkung bestimmen kann.

Bislang wurde versucht, durch eine geschickte Wahl von Einstellparametern, die die Signalverarbeitung im Hörhilfegerät beeinflussen, die Sprachverständlichkeit bei der Benutzung des Hörhilfegerätes zu verbessern. Hierzu wurden unterschiedliche, nicht lineare Anpassformeln mit unterschiedlichen Zielsetzungen verwendet. Eine unter der Bezeichnung "DSL i/o" bezeichnete Anpassformel zielt im Wesentlichen darauf ab, die Lautheit einer normal hörenden Person zu restaurieren. Im Unterschied hierzu wird bei der als "NAL-NL1" bekannten Anpassformel das Ziel verfolgt, eine maximale Sprachverständlichkeit zu erreichen. Während die Lautheit unabhängig von der Art des Schalls restauriert werden kann, hängt die Sprachverständlichkeit von der spektralen Energieverteilung des Sprachsignals relativ zur spektralen Energieverteilung des Störsignals ab. Diese Abhängigkeit vom Störschallspektrum bzw. Störschallpegel bleibt bei NAL-NL1 jedoch unberücksichtigt, da diese Anpassformel von einer Optimierung der Sprachverständlichkeit in Ruhe ausgeht. Eine weitere Einschränkung bei den genannten Formeln besteht darin, dass ihnen eine statische Kennlinie zugrunde liegt, d.h., dass durch die entsprechende Anpassformel nicht zu jedem beliebigen Zeitpunkt, sondern nur im zeitlichen Mittel, die optimale Lautheit bzw. Sprachverständlichkeit erreicht werden kann.

Bei der Anpassformel NAL-NL1 wird die für einen bestimmten Hörverlust und ein bestimmtes Eingangssignal optimale Verstärkung im Voraus ("offline") und nicht im Hörhilfegerät bestimmt. Dazu wird für jede Hörverlust/Eingangspegelkombination für das mittlere Sprachspektrum mit einem an den Hörverlust angepassten Sprachverständlichkeits- und Lautheitsmodell diejenige Verstärkung bestimmt, die zu einer optimierten Sprachverständlichkeit führt, ohne bei der Versorgung durch das Hörhilfegerät die Lautstärke zu überschreiten, die ein Normalhörender in dieser Situation erfahren würde.

Ferner ist bekannt, adaptive Filter zur Störgeräuschbefreiung vorzusehen. Ohne Berücksichtigung des Hörverlustes wird aufgrund statischer Annahmen über Sprachsignal und Störsignal die Verstärkung so berechnet, dass das Sprachsignal aus der Sprachsignal/Störsignalmischung in einem statistischen Sinne ohne Berücksichtigung perzeptiver Effekte bei Sprachverständlichkeit rekonstruiert wird. Beispiele für diese Vorgehensweise sind die Verwendung eines Wienerfilters oder die spektrale Subtraktion.

Aus der WO 87/00366 A1 ist ein Verfahren sowie ein System zur Störgeräuschunterdrückung bei Hörgeräten bekannt. Dabei wird ein akustisches Eingangssignal in mehrere Frequenzbänder aufgespaltet und das Signal-Rausch-Verhältnis in den einzelnen Frequenzbändern bestimmt. In Abhängigkeit dieses Verhältnisses wird dann die Verstärkung in den einzelnen Frequenzbändern eingestellt.

Aufgabe der vorliegenden Erfindung ist es, die Sprachverständlichkeit in einer Störsignal behafteten Umgebung zu verbessern.

Diese Aufgabe wird durch ein Verfahren mit den Verfahrensschritten gemäß Patentanspruch 1 gelöst.

Ferner wird die Aufgabe gelöst durch ein Hörhilfegerät mit den Merkmalen gemäß Patentanspruch 5.

Durch eine simultane Optimierung der Sprachverständlichkeit einerseits und der Lautheit andererseits auf der Grundlage des aktuellen Sprach- und Störgeräuschspektrums wird sowohl die Sprachverständlichkeit verbessert und zugleich dem Hörgeräteträger der Lautheitseindruck einer normal hörenden Person vermittelt. Dieses Ziel wird dadurch erreicht, dass die Verstärkung nicht wie bisher statisch und "offline" berechnet, sondern dynamisch (zeitvariant) im Hörhilfegerät ermittelt und eingestellt wird. Dadurch können die zeitabhängig tatsächlich vorliegenden Sprachsignal/Störsignalmischungen und auch die Hörgeräte-Signalverarbeitung bei der Verstärkungseinstellung berücksichtigt werden.

Vorteilhaft werden bei der automatischen Einstellung der Verstärkung auch die individuellen audiometrischen Daten des Hörgeräteträgers, z.B. die Hörschwelle oder die Unbehaglichkeitsschwelle, bei der Einstellung der Verstärkung mit berücksichtigt. In die Einstellung der Verstärkung gehen somit nicht nur Daten des Hörverlustes ein, sondern gleichzeitig auch Eigenschaften des Störgeräusches. Dadurch werden die Auswirkungen des Hörverlustes auf die Sprachwahrnehmung mit berücksichtigt. Da die Berechnung von Einstellparametern bezüglich der Verstärkung "online" vollzogen wird, d.h. während des normalen Betriebes des Hörhilfegerätes unter tatsächlich vorliegenden Sprach- und Störsignalen, können Auswirkungen der Hörgeräte-Signalverstärkung auf die Sprachverständlichkeit berücksichtigt werden. Beispielsweise wird die Sprachverständlichkeit durch die effektive Kompression beeinflusst.

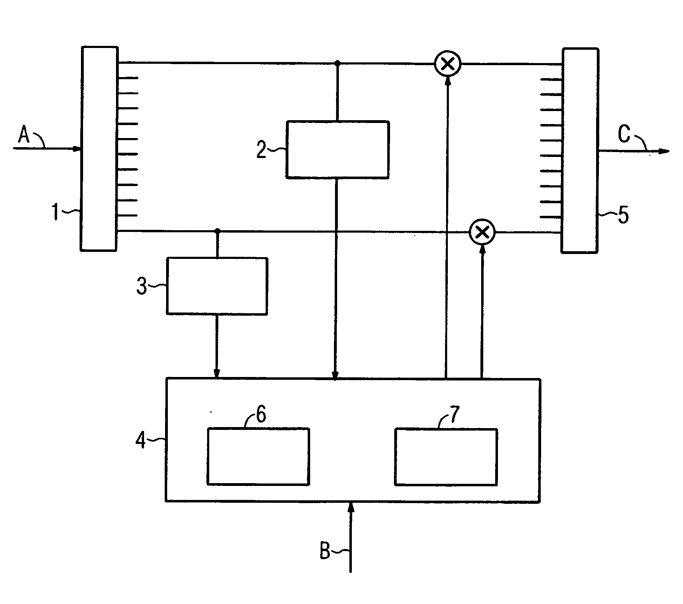

In der Figur ist ein Ausführungsbeispiel der Erfindung dargestellt.

Durch ein Hörhilfegerät wird ein akustisches Eingangssignal A in ein elektrisches Signal gewandelt. Das elektrische Signal A ist, gegebenenfalls nach einer A/D-Wandlung, zunächst einer Filterbank 1 zugeführt. Durch diese wird das elektrische Eingangssignal A in mehrere Frequenzbänder aufgeteilt. Aus den Signalen der einzelnen Frequenzbänder werden der Gesamtpegel, der Sprachsignalpegel und der Störgeräuschpegel ermittelt. Diese Pegelermittlung kann auch durch Pegelschätzung unter Verwendung bekannter Schätzverfahren erfolgen. Zur Verbesserung der Übersichtlichkeit sind im Ausführungsbeispiel nur für zwei der Frequenzbänder Einheiten 2 bzw. 3 zur Pegelermittlung eingezeichnet. Die ermittelten Pegel werden einer Einrichtung 4 zum Ermitteln von Parametern zur automatischen Einstellung der Verstärkung zugeführt. In diese gehen neben den Signalpegeln auch individuelle audiometrische Daten B des Hörgeräteträgers, z.B. die Hörschwelle oder die Unbehaglichkeitsschwelle ein. Der Verstärkungsberechnung wird sowohl ein Lautheitsmodell 6 als auch ein Sprachverständlichkeitsmodell 7 zugrunde gelegt. Vorteilhaft wird für jeden Zeitabschnitt mit einem mathematischen Optimierungsverfahren die Verstärkung der einzelnen Kanäle so festgelegt, dass die Sprachverständlichkeit optimiert wird, wobei der Lautheitseindruck, den ein Normalhörender bei gleichem akustischem Eingangssignal hat, zumindest im Wesentlichen erhalten bleibt. Hierfür werden die elektrischen Signale in den einzelnen Frequenzbändern jeweils mit einem in der Einrichtung 4 ermittelten Faktor multipliziert, so dass für die Sprachverständlichkeit wesentliche Frequenzbänder hervorgehoben und diesbezüglich weniger wichtige Frequenzbänder entsprechend weniger verstärkt oder sogar abgesenkt werden. Anschließend werden die Signale der einzelnen Frequenzbänder in einer Syntheseeinheit 5 wieder zu einem elektrischen Ausgangssignal C zusammengeführt und gegebenenfalls weiterverarbeitet.

Im Unterschied zu dem dargestellten Ausführungsbeispiel können anstelle der Signalpegel auch andere Kennwerte der Schallfeldenergie herangezogen werden.

## Patentansprüche

1. Verfahren zur automatischen Verstärkungseinstellung in einem Hörhilfegerät mit folgenden Schritten:
- Wandlung des akustischen Eingangssignals (A) in ein elektrisches Signal,
- Ermittlung eines Sprachsignalpegels und eines Störsignalpegels in mehreren Frequenzbändern des elektrischen Signals,
- Ermittlung von Parametern zur automatischen Einstellung der Verstärkung des elektrischen Signals (A) in Abhängigkeit des Sprachsignalpegels, des Störsignalpegels und der Frequenz des elektrischen Signals (A), wobei die Ermittlung der Parameter unter Einbeziehung eines Lautheitsmodells (6) und eines Sprachverständlichkeitsmodells (7) erfolgt.

2. Verfahren nach Anspruch 1, wobei neben dem Sprachsignalpegel und dem Störsignalpegel auch der Gesamtsignalpegel des elektrischen Signals in den einzelnen Frequenzbändern sowie der Gesamtsignalpegel des elektrischen Signals über die gesamte Bandbreite des elektrischen Eingangssignals ermittelt werden und die Parameter in Abhängigkeit dieser Gesamtsignalpegel ermittelt werden.

3. Verfahren nach Anspruch 1 oder 2, wobei zur Ermittlung des Sprachsignalpegels und/oder des Störsignalpegels eine Pegelschätzung vorgenommen wird.

4. Verfahren nach einem der Ansprüche 1 bis 3, wobei die Ermittlung der Parameter unter Berücksichtigung individueller audiometrischer Daten (B) eines Hörgeräteträgers erfolgt.

5. Hörhilfegerät zur Durchführung des Verfahrens nach einem der Ansprüche 1 bis 4, mit einer Filterbank 1 zur Aufteilung eines elektrischen Signals in Frequenzbänder, einer Einrichtungen (2, 3) zur Ermittlung eines Sprachsignalpegels und eines Störsignalpegels in den Frequenzbändern und einer Einrichtung (4) zum Ermitteln von Parametern zur automatischen Einstellung der Verstärkung des elektrischen Signals in Abhängigkeit des Sprachsignalpegels und des Störsignalpegels, wobei der Einrichtung (4) zum Ermitteln von Parametern zur automatischen Einstellung der Verstärkung des elektrischen Signals ein Lautheitsmodell (6) sowie ein Sprachverständlichkeitsmodell (7) zugrunde liegen.

6. Hörhilfegerät nach Anspruch 5, wobei der Einrichtung (4) zum Ermitteln von Parametern zur automatischen Einstellung der Verstärkung audiometrische Daten (B) zugeführt sind.

## Claims

1. Method for automatic amplification adjustment in a hearing aid device, with the following steps:
- transducing the acoustic input signal (A) into an electrical signal,
- determining a speech signal level and a noise signal level in a plurality of frequency bands of the electrical signal
- determining parameters for automatic adjustment of the amplification of the electrical signal (A) as a function of the speech signal level, the noise signal level and frequency of the electrical signal (A), with the parameters being determined by including a loudness model (6) and a speech intelligibility model (7).

2. Method according to claim 1,
with, in addition to the speech signal level and the noise signal level, the overall signal level of the electrical signal in the individual frequency bands and the overall signal level of the electrical signal over the entire bandwidth of the electrical input signal also being determined and the parameters being determined as a function of this overall signal level.

3. Method according to claim 1 or 2, with a level estimation being performed in order to determine the speech signal level and/or the noise signal level.

4. Method according to one of claims 1 to 3, with the parameters being determined by taking individual audiometric data (B) of a hearing device wearer into account.

5. Hearing aid device for implementing the method according to one of claims 1 to 4, with a filter bank 1 for dividing an electrical signal into frequency bands, a facility (2, 3) for determining a speech signal level and a noise signal level in the frequency bands and a facility (4) for determining parameters for automatic adjustment of the amplification of the electrical signal as a function of the speech signal level and the noise signal level, with a loudness model (6) as well as a speech intelligibility model (7) underlying the facility (4) for determining parameters for automatic adjustment of the amplification of the electrical signal.

6. Hearing aid device according to claim 5, with audiometric data (B) being fed to the facility (5) for determining parameters for audiometric adjustment of the amplification.

## Revendications

1. Procédé de réglage automatique de l'amplification d'une prothèse auditive comprenant les stades suivantes :
- on transforme le signal (A) acoustique d'entrée en un signal électrique,
- on détermine un niveau de signal vocal et un niveau de signal parasite dans plusieurs bandes de fréquence du signal électrique,
- on détermine des paramètres de réglage automatique de l'amplification du signal (A) électrique en fonction du niveau du signal vocal, du niveau du signal parasite et de la fréquence du signal (A) électrique, la détermination s'effectuant en se rapportant à un modèle (6) de volume sonore et à un modèle (7) de netteté de la parole.

2. Procédé suivant la revendication 1 dans lequel on détermine, outre le niveau du signal vocal et le niveau du signal parasite, également le niveau global du signal électrique dans les diverses bandes de fréquence ainsi que le niveau global du signal électrique sur toute la largeur de bande du signal électrique d'entrée et on détermine les paramètres en fonction de ces niveaux globaux du signal.

3. Procédé suivant la revendication 1 ou 2 dans lequel, pour la détermination du niveau du signal vocal et/ou du niveau du signal parasite, on effectue une estimation de niveau.

4. Procédé suivant l'une des revendications 1 à 3 dans lequel on effectue la détermination des paramètres en tenant compte de données (B) individuelles audiométriques d'un porteur de la prothèse auditive.

5. Prothèse auditive pour la mise en oeuvre du procédé suivant l'une des revendications 1 à 4 comprenant une rampe (1) de filtre pour subdiviser un signal électrique en des bandes de fréquence, des dispositifs (2,3) de détermination d'un niveau de signal vocal et d'un niveau de signal parasite dans les bandes de fréquence et un dispositif (4) de détermination de paramètres pour régler automatiquement l'amplification du signal électrique en fonction du niveau du signal vocal et du niveau du signal parasite, le dispositif (4) de détermination de paramètres pour le réglage automatique de l'amplification du signal électrique reposant sur un modèle (6) de volume sonore ainsi que sur un module (7) de netteté de la parole.

6. Prothèse auditive suivant la revendication 5 dans laquelle des données (B) audiométriques sont, pour le réglage automatique de l'amplification, envoyées au dispositif (4) de détermination de paramètre.
